# FASCICULE DE BREVET EUROPEEN

(11) **EP 2 045 352 B1**
(45) Date de publication et mention de la délivrance du brevet: **13.06.2012**
(21) Numéro de dépôt: 08290874.0
(22) Date de dépôt: 17.09.2008
(51) Int. Cl.: C23C 14/02, C23C 14/06, C23C 14/16, B82Y 30/00, B26B 21/60

(54) **Procédé d'obtention d'une surface dure à l'échelle nanométrique**
Verfahren zur Erzeugung einer harten Oberfläche im Nanometerbereich
Method of obtaining a hard surface on the nanometric scale

(30) Priorité: 28.09.2007 FR 0706816
(43) Date de publication de la demande: 08.04.2009
(73) Titulaire: Commissariat à l'Énergie Atomique et aux Énergies Alternatives, 75015 Paris (FR)
(72) Inventeur: Ducros, Cédric, 38690 Bevenais (FR); Sanchette, Frédéric, 38620 Montferrat (FR); Sanzone, Vincent, 38530 Chapareillan (FR)
(74) Mandataire: Noel, Chantal Odile

(56) Documents cités:
- WO-A-97/10083
- WO-A-97/12757
- JP-A- 2005 212 025
- PIERSON J F ET AL: "Structural and electrical properties of sputtered titanium boronitride films" SURFACE & COATINGS TECHNOLOGY ELSEVIER SWITZERLAND, vol. 142-144, juillet 2001 (2001-07), pages 906-910, XP002476495 ISSN: 0257-8972

## Description

L'invention concerne un procédé de formation d'un revêtement d'une épaisseur inférieure ou égale à 200 nm et d'une dureté supérieure ou égale à 20 GPa.

Elle concerne également les dispositifs comprenant un revêtement obtenu par ce procédé.

Les couches minces ultra dures sont largement utilisées dans de nombreux domaines afin de protéger certains ensembles ou pièces contre l'usure abrasive. Ces pièces peuvent entre des micro-objets (MEMs), mais également des objets dont on souhaite conserver des aspects géométriques comme par exemple le rayon d'une arête de coupe de lame de rasoir.

Les revêtements de type Metal-BN sont largement utilisés dans le domaine mécanique afin d'améliorer la dureté de surface des composants mécaniques.

Les revêtements de type Metal-BN les plus couramment utilisés sont le TiBN, le ZrBN et le TiAlBN.

En particulier, les revêtements de structure nanocomposite sont très étudiés dans le but d'obtenir des niveaux de dureté très élevés.

Le procédé de pulvérisation cathodique magnétron en mode co-pulvérisation réactive est bien connu dans le domaine de la fabrication des couches minces dures.

Ce procédé permet d'obtenir des couches de composition extrêmement précise avec une rugosité de surface réduite. Ces couches ont des épaisseurs supérieures à 2 micromètres, pour atteindre des duretés de la couche de 30 GPa, mais il ne permet pas d'obtenir des couches dures ayant un niveau d'adhérence suffisant sur le support, en particulier pour des applications dans lesquelles les pièces revêtues sont fortement sollicitées thermo-mécaniquement.

On connaît également le procédé d'évaporation par arc cathodique pour l'élaboration de couches dures, mais il n'a pas, jusqu'à présent, permis d'obtenir des couches dures inférieures à 2 micromètres.

Ainsi, pour la formation de couches dures pour des applications dans lesquelles la pièce revêtue est fortement sollicitée thermo-mécaniquement, on utilise à l'heure actuelle le procédé d'évaporation par arc cathodique car il permet d'obtenir des niveaux d'adhérence de la couche dure sur la pièce revêtue très élevés du fait du taux d'ionisation très élevé de la vapeur générée par la technique de l'évaporation par arc cathodique qui est d'environ 90% alors que ce taux n'est que de quelques pourcents, 10% au mieux, pour la pulvérisation cathodique magnétron. De plus, dans le procédé d'évaporation par arc cathodique, le bombardement de la couche en cours de croissance est favorisé par ce taux élevé d'ionisation en appliquant une tension de polarisation négative sur les pièces à revêtir.

Cependant, le procédé d'évaporation par arc cathodique génère une rugosité de surface importante qui ne permet pas d'obtenir des couches dures ne modifiant pas la géométrie des pièces revêtues pour des épaisseurs inférieures à 2 micromètres.

En particulier, l'aspect rugosité de surface est important car pour des épaisseurs totales de revêtement de l'ordre de 200 nm, une rugosité de surface du même ordre est rédhibitoire pour une application mécanique.

JP 2005-212 025 A décrit un outil ayant une surface revêtue par une couche intermédiaire composée, par exemple, de TiZrBN avec une épaisseur entre 0,05 et 20 µm. La couche est déposée, par exemple, par pulvérisation cathodique.

L'invention vise à pallier les inconvénients des procédés de l'art antérieur en proposant un procédé d'obtention de couches dures en un matériau de structure nanocomposite, par la méthode de pulvérisation cathodique magnétron, qui permet d'obtenir des couches dures ayant une épaisseur inférieure ou égale à 200 nm et une dureté supérieure ou égale à 20 GPa, avec une rugosité de surface réduite et un niveau d'adhérence important.

A cet effet, l'invention propose un procédé de formation sur un support, d'un revêtement d'une épaisseur inférieure ou égale à 200 nm et d'une dureté supérieure ou égale à 20 GPa, en un matériau de structure nanocomposite à base de titane, de zirconium, de bore et d'azote, qui comprend les étapes suivantes:
a) dépôt par pulvérisation cathodique magnétron d'une couche en titane, sur au moins une surface dudit support sous une pression partielle d'argon de 1 Pa,
b) dépôt par pulvérisation cathodique magnétron d'une couche en nitrure de titane, sur la couche obtenue à l'étape a), par introduction d'azote dans l'enceinte de pulvérisation cathodique tout en maintenant une pression partielle de 1 Pa,
c) dépôt d'une couche en un matériau composite nanostructuré à base de titane, de Zr, de bore et d'azote, sur la couche obtenue à l'étape b), par pulvérisation cathodique magnétron en mode co-pulvérisation active par application d'une puissance X sur une cible source de titane, et d'une puissance Y sur une cible source de ZrB₂, le rapport X/Y étant compris entre 3/5 et 5/3 inclus, et injection simultanée d'un mélange gazeux composé d'argon et d'azote, l'azote représentant au moins 10% en volume du volume total du mélange gazeux, tout en maintenant une pression partielle de 1 Pa et en appliquant une tension de polarisation de -300V, dans l'enceinte de pulvérisation cathodique.

De préférence, dans le procédé de l'invention, à l'étape c), le pourcentage d'azote introduit dans l'enceinte de pulvérisation cathodique magnétron est de 10% en volume par rapport au volume total du mélange gazeux introduit.

Toujours de préférence, dans le procédé de l'invention, le rapport des puissances X/Y appliquées sur les cibles, à l'étape c), est de 1.

L'invention englobe également les dispositifs comprenant un revêtement obtenu par le procédé de l'invention, et plus particulièrement les lames de rasoir. Il est à noter que pour les lames de rasoir, seules les arêtes peuvent être revêtues et non toute la lame de rasoir.

L'invention sera mieux comprise et d'autres caractéristiques et avantages de celle-ci apparaitront plus clairement à la lecture de la description explicative qui suit et qui est faite en référence aux figures dans lesquelles:
- la Figure 1 représente schématiquement un dispositif de pulvérisation cathodique magnétron en mode co-pulvérisation active,
- la Figure 2 représente schématiquement une coupe d'une pièce dont une surface est revêtue avec le revêtement de l'invention,
- la Figure 3 représente l'influence du rapport de puissance X/Y sur la composition en pourcentage atomique et la dureté de la dernière couche du revêtement de l'invention,
- la Figure 4 représente l'évolution de la dureté de la dernière couche de revêtement de l'invention en fonction du rapport débit d'azote/débit total du mélange gazeux introduit dans l'enceinte de pulvérisation cathodique magnétron, et
- la Figure 5 est une photographie obtenue par microscopie électronique en transmission à haute résolution de la structure nanocomposite de la dernière couche du revêtement obtenue par le procédé de l'invention. Dans cette photographie, 1 cm représente 5 manomètres de la couche montrée.

L'invention consiste à déposer sur un support métallique, plastique ou céramique, ayant au moins une surface avec un poli miroir, un revêtement nanostructuré de type nanocomposite à base de Ti, Zr, B et N ayant des duretés supérieures à 20 GPa pour des épaisseurs de revêtement inférieures ou égales à 200 nm.

L'épaisseur classiquement déposée dans l'art antérieur est de l'ordre de 2 à 3 micromètres pour de tels revêtements, soit 10 fois plus que dans l'invention, pour obtenir des niveaux de dureté de l'ordre de 30 GPa.

L'obtention de duretés extrêmement importantes pour des épaisseurs de dépôt aussi faibles, avec des rugosités de surface faibles, est rendue possible dans l'invention par l'élaboration d'un revêtement de composition à base de Ti, Zr, B et N, avec une structure nanocomposite et une architecture particulière.

Le procédé de l'invention est un procédé de pulvérisation cathodique magnétron en mode co-pulvérisation réactive dans lequel, outre l'architecture particulière du revêtement, le rapport de puissance appliqué sur les sources d'une part de Ti, et d'autre part de ZrB₂, est contrôlé, l'azote étant introduit sous forme de gaz en mélange avec de l'argon également à un rapport particulier.

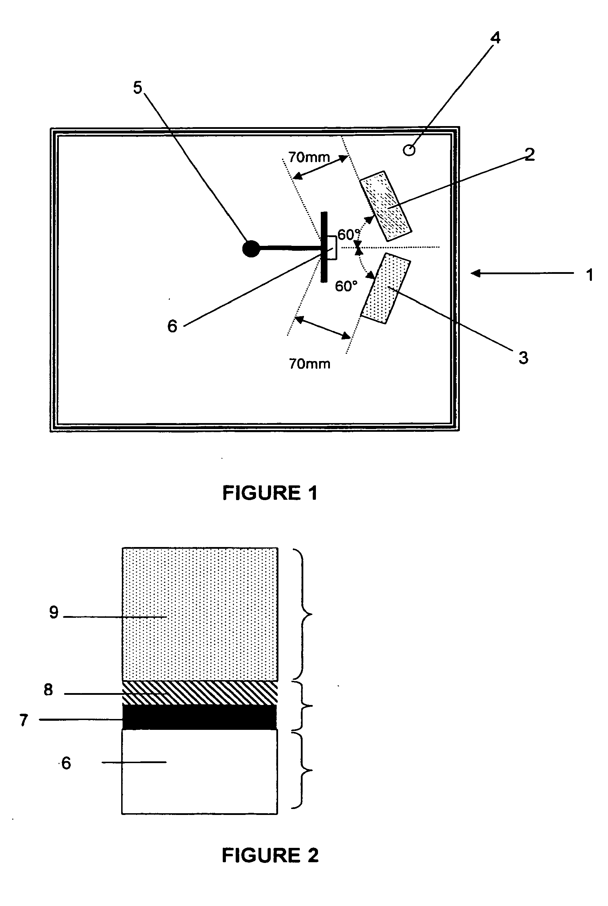

Le dispositif de pulvérisation cathodique magnétron en mode co-pulvérisation réactive est représenté schématiquement en figure 1.

Ce dispositif est constitué d'une enceinte, notée 1 en figure 1, comportant une entrée de gaz, notée 4 en figure 1. Au centre de l'enceinte se trouve un porte-échantillon, noté 5 en figure 1, sur lequel on place l'échantillon, noté 6 en figure 1, dont au moins une surface est à revêtir.

Deux cibles, l'une en ZrB₂, notée 2 en figure 1, et l'autre en titane, notée 3 en figure 1, sont positionnées symétriquement par rapport à l'axe de symétrie du porte-échantillon 5, et face à lui, en formant chacune un angle de 60° par rapport à l'axe de symétrie du porte-échantillon 5.

La distance entre le centre de l'échantillon 6 et la surface des cibles 2, 3 est de 70 mm.

L'échantillon 6 est centré sur le porte-échantillon 5 de façon à avoir la même distance entre l'échantillon 6 et les deux cibles 2, 3. '

Ensuite, une puissance est appliquée sur l'une et/ou l'autre des cibles 2, 3, ce qui provoque une ionisation du matériau de la cible qui vient se déposer sur les surfaces dénudées de l'échantillon 6.

Ainsi, par ce procédé, on obtient des revêtements très fins et de rugosité de surface faible. Le matériau obtenu est un matériau de type nanocomposite de composition à base de Ti, Zr, B et N bien connu pour avoir des propriétés de dureté élevée.

Afin d'optimiser l'adhérence de ce dépôt sur l'échantillon, en raison du faible taux d'ionisation obtenu avec le procédé de pulvérisation cathodique magnétron, une architecture particulière du revêtement doit être respectée. Cette architecture est montrée en figure 2.

Comme on le voit en figure 2, dans le procédé de l'invention, une première couche, notée 7 en figure 2, en Ti est déposée sur la surface à revêtir de l'échantillon 6, couche 7 sur laquelle une autre couche, notée 8 en figure 2, en TiN est déposée, avant de procéder au dépôt de la couche, notée 9 en figure 2, en matériau nanostructuré, elle-même.

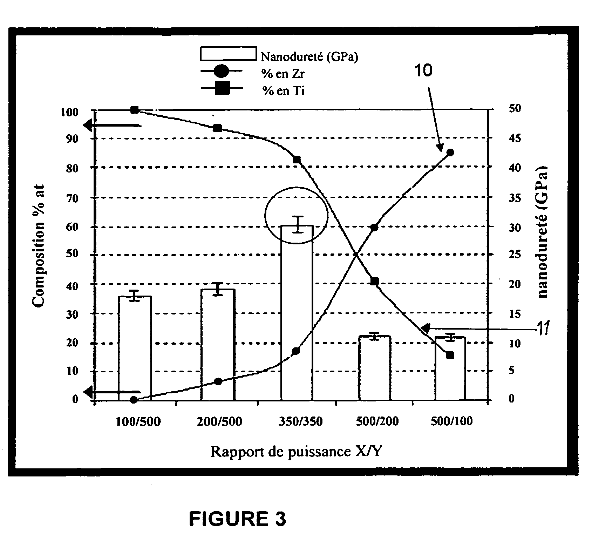

La composition le la couche 9 à base de Ti, Zr, B et N est obtenue dans l'invention, en appliquant un rapport de puissance X/Y, dans lequel X représente la puissance appliquée sur la cible 2 de ZrB₂, et Y représente la puissance appliquée sur la cible 3 de titane, compris dans l'intervalle entre 3/5 et 5/3 inclus, avec préférentiellement un rapport de 1, comme on le voit en figure 3.

En effet, la figure 3 représente la composition atomique en Ti et en Zr, ainsi que la dureté mesurée par nanoindentation de couches élaborées à différents rapports de puissance X/Y appliqués sur les cibles 2,3 de pulvérisation.

En figure 3, l'abscisse représente les rapports de puissances exprimées en watts. Autrement dit, lorsqu'un rapport de 100/500 est indiqué en abscisse, cela signifie qu'une puissance de 100 W a été appliquée sur la cible 2 de ZrB₂ et qu'une puissance de 500 W a été appliquée en même temps sur la cible 3 de titane. En figure 3, l'ordonnée gauche représente la composition, en pourcentage atomique, du revêtement obtenu : la courbe notée 10 en figure 3 représente l'évolution du pourcentage atomique de zirconium la couche 9 obtenue, et la courbe, notée 11 en figure 3, représente l'évolution du pourcentage atomique en titane de la couche 9 obtenue, selon le rapport X/Y des puissances appliquées sur les cibles 2, 3 de ZrB₂ et de Ti.

L'ordonnée droite de la figure 3 représente l'échelle de nanodureté en GPa des couches obtenues selon le rapport des puissances appliquées. Ces duretés sont représentées sous forme de barres dans la figure 3.

Ainsi, on voit en figure 3 que des couches d'une dureté supérieure à 20 GPa sont obtenues lorsqu'on applique des rapports de puissances X/Y compris entre 3/5 et 5/3 inclus.

La dureté est mesurée par nanoindentation par la méthode décrite dans *Nanoindentation of coatings,* J. Phys. D : Appl. Phys. 38 (2005) R393-R413.

Mais, le paramètre rapport de puissance X/Y n'est pas le seul paramètre du procédé.

En effet, pour obtenir la couche 9 de composition et de dureté voulue, il faut introduire dans l'enceinte de pulvérisation de l'azote.

Ceci est fait en introduisant dans l'enceinte un mélange gazeux constitué d'argon et d'azote, contenant au moins 10% en volume d'azote, par rapport au volume total du mélange argon + azote. Ce pourcentage permet d'obtenir un régime de pulvérisation pleinement réactif, c'est-à-dire que les cibles sont complètement empoisonnées.

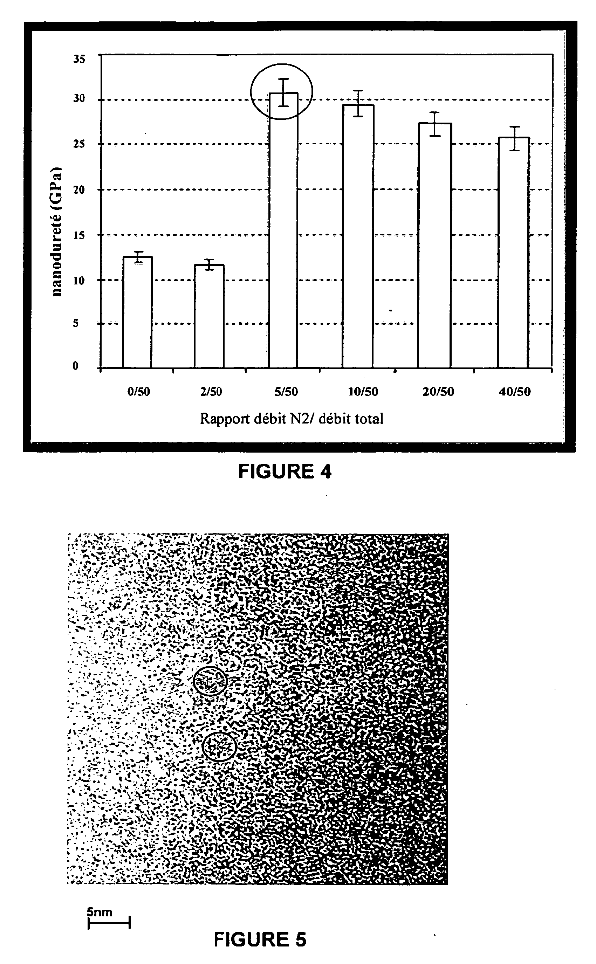

Le pourcentage optimal d'azote dans le mélange est de 10%, comme on le voit en figure 4.

La figure 4 représente la nanodureté, en GPa, de couches élaborées à partir de différents pourcentages d'azote dans le mélange argon + azote. Ainsi, on voit qu'un pourcentage d'azote de 10% est optimal mais qu'au-delà des nano duretés de 20 GPa sont également obtenues.

Les couches selon l'invention sont déposées à température ambiante.

Afin de mieux faire comprendre l'invention, on va en décrire maintenant un mode de réalisation qui est donné à titre purement illustratif et non limitatif de l'invention.

### Exemple 1

Cet exemple sera décrit en référence aux figures 1 et 2.

### a) décapage de la pièce à revêtir

L'échantillon 6 dont une surface est à revêtir est un disque en acier rapide de type M2 poli miroir.

L'échantillon 6 est placé sur le porte-échantillon 5 représenté en figure 1, centré de façon à avoir la même distance entre l'échantillon 6 et les cibles 2 et 3, respectivement en ZrB₂ et en Ti.

Tout d'abord, l'enceinte 1 est mise sous un vide secondaire d'environ 10⁻⁶ mbar.

L'échantillon 6 est disposé de telle façon qu'il ne soit pas en face des cibles 1 et 2 de pulvérisation.

La tension de pulvérisation de l'échantillon est de -500 V et la pression dans l'enceinte est une pression partielle d'argon pur de 1 Pa. L'argon est introduit par l'entrée de gaz à un débit de 50 sccm. La durée de décapage de la pièce est de 4 minutes.

La pièce n'étant pas disposée face aux cibles, il n'y a pas de revêtement réalisé.

### b) dépôt de la couche 7 en titane

Ensuite, on arrête l'application de puissance sur la cible 2 de ZrB₂ et on fixe la puissance appliquée sur la cible 3 de titane à 350W, ce qui correspond, pour les dimensions de la cible 3 de titane utilisée ici, à une puissance appliquée de 1,2W/cm², toujours à une pression partielle d'argon de 1 Pa.

L'échantillon 6 est disposé face aux cibles, c'est-à-dire centré sur le porte-échantillon de façon à ce qu'il y ait la même distance entre l'échantillon 6 et les deux cibles 2 et 3.

On applique une tension de polarisation sur l'échantillon progressive de -500 à -300 V.

Cette étape correspond à l'étape de dépôt de la couche de Ti notée 7 en figure 2, sur la surface de l'échantillon 6. La durée de cette étape de dépôt de titane est d'une minute. L'épaisseur de la couche de Ti obtenue est de 5 nm.

### c) dépôt de la couche 8 en TiN

On procède alors au dépôt de la couche, notée 8 en figure 2, en nitrure de titane.

Pour cela, on introduit comme gaz réactif un mélange d'argon et d'azote, tout en conservant une pression de 1 Pa dans l'enceinte 1. Le débit d'argon est de 20 sccm et le débit d'azote est de 30 sccm. La durée de dépôt est de 30 secondes. La couche 8 obtenue est une couche en nitrure de titane stoechiométrique. L'épaisseur de la couche 8 de nitrure de titane est de 15 nm.

### d) dépôt de la couche 9 en matériau nanostructuré

Ensuite, on procède au dépôt de la couche 9 à base de Ti, Zr, B et N. Pour cela, on augmente la puissance appliquée sur la cible 2 de ZrB₂ de 0 à 350 W, ce qui correspond à une puissance appliquée sur la cible 2 de 1,2W/cm², tout en maintenant la puissance appliquée sur la cible 3 en Ti à 350 W. La durée du dépôt est de 6 minutes. Le débit d'azote est de 5 sccm et le débit d'argon est de 45 sccm, c'est-à-dire un pourcentage d'azote de 10% en volume par rapport au volume gazeux total.

La couche 9 obtenue par ce procédé est un matériau de structure nanocomposite à base de titane, de zirconium, de bore et d'azote. Les cristallites de cette phase nanocomposite sont constituées de titane, de zirconium et d'azote, et la phase amorphe est de type boronitrure, c'est-à-dire à base de titane, de zirconium, de bore et d'azote.

Il s'agit bel et bien d'une structure nanocomposite comme le montre la figure 5 qui représente une photographie obtenue par microscopie électronique en transmission haute résolution de la couche 9 obtenue à cet exemple. La taille des nanocristallites est d'environ 4 nm et la rugosité de cette couche est de 4 nm. La rugosité, Ra, est mesurée par profilométrie à l'aide d'un palpeur mécanique, selon la norme ISO 4287.

L'épaisseur de cette couche 9 est de 100 nm et sa dureté est de l'ordre de 30 GPa comme on le voit en figures 3 et 4.

Les applications industrielles de ce type de revêtement sont multiples, tout comme les domaines dans lesquels des couches dures de dureté supérieure à 20 GPa doivent rester extrêmement fines, c'est-à-dire d'une épaisseur inférieure ou égale à 200 nm sont multiples.

Ainsi, la première application du procédé de l'invention est le revêtement de lames de rasoir afin d'améliorer la résistance à l'usure des arêtes de coupe de ces lames. Actuellement, la dureté de surface d'une lame est de 7 GPa. Les couches dures dans ce domaine ne doivent pas dépasser 100 nm afin de préserver une certaine acuité d'arête.

Le second type d'application est la protection anti-usure des micro-objets ou MEMs. En effet, ce domaine est aussi confronté à des problèmes d'usure abrasive sévère sur les pièces en contact tels que des micro-engrenages. L'application d'une couche dure sur ce type d'objet est indispensable et ne doit pas affecter la géométrique à l'échelle micrométrique de cet objet. Dans ce cas également, la possibilité de combiner une couche très dure et très fine représente un intérêt majeur.

## Revendications

1. Procédé de formation d'un revêtement d'une épaisseur inférieure ou égale à 200 nm et d'une dureté supérieure ou égale à 20 GPa, en un matériau de structure nanocomposite à base de titane, de zirconium, de bore et d'azote, sur un support (6) **caractérisé en ce qu'**il comprend les étapes suivantes:
a) dépôt par pulvérisation cathodique magnétron d'une couche (7) en titane, sur au moins une surface d'un support (6) sous une pression partielle d'argon de 1 Pa,
b) dépôt par pulvérisation cathodique magnétron d'une couche (8) en nitrure de titane, sur la couche (7) obtenue à l'étape a) par introduction d'azote dans l'enceinte de pulvérisation cathodique (1) tout en maintenant une pression partielle de 1 Pa,
c) dépôt d'une couche (9) en un matériau composite nanostructuré à base de titane, de zirconium, de bore et d'azote, sur la couche (8) obtenue à l'étape b), par pulvérisation cathodique magnétron en mode co-pulvérisation active par application d'une puissance X sur une cible 3 source de titane et d'une puissance Y sur une cible 2 source de ZrB₂, le rapport X/Y étant compris entre 3/5 et 5/3 inclus, et injection simultanée d'un mélange gazeux composé d'argon et d'azote, l'azote représentant au moins 10% en volume, du volume total du mélange gazeux, tout en maintenant une pression partielle de 1 Pa et en appliquant une tension de polarisation de -300 V, dans l'enceinte de pulvérisation cathodique (1).

2. Procédé selon la revendication 1 **caractérisé en ce qu'**à l'étape c), l'azote représente 10% en volume du volume total du mélange gazeux.

3. Procédé selon la revendication 1 ou 2 **caractérisé en ce qu'**à l'étape c), le rapport X/Y = 1.

4. Dispositif comprenant un revêtement obtenu par le procédé selon l'une quelconque des revendications précédentes.

5. Dispositif selon la revendication 4 **caractérisé en ce qu'**il s'agit d'une lame de rasoir.

## Claims

1. Process for the formation on a support (6) of a coating having a thickness less than or equal to 200 nm and a hardness greater than or equal to 20 GPa in a nanocomposite structure material based on titanium, zirconium, boron and nitrogen, **characterised in that** it comprises the following steps:
a) depositing by magnetron cathode sputtering a titanium layer (7) on at least one surface of a support (6) under a partial pressure of argon of 1 Pa,
b) depositing by magnetron cathode sputtering a titanium nitride layer (8) on the layer (7) obtained in step a) by introducing nitrogen into the cathode sputtering enclosure (1) whilst maintaining a partial pressure of 1 Pa, and
c) depositing by magnetron cathode sputtering in an active co-sputtering mode a layer (9) of nanostructured composite material based on titanium, zirconium, boron and nitrogen on the layer (8) obtained in step b) by application of a power X to a target 3 that is a source of titanium and a power Y to a target 2 that is a source of ZrB₂, the ratio X/Y being in the range 3/5 to 5/3 inclusive, and simultaneous injection of a gas mixture composed of argon and nitrogen, the nitrogen representing at least 10% by volume of the total volume of the gas mixture, whilst maintaining a partial pressure of 1 Pa and applying a polarization voltage of -300 V in the cathode sputtering enclosure (1).

2. Process according to claim 1 **characterised in that** in step c) the nitrogen represents 10% by volume of the total volume of the gas mixture.

3. Process according to claim 1 or claim 2 **characterised in that** in step c) the ratio X/Y = 1.

4. Device comprising a coating produced by the process according to any one of the preceding claims.

5. Device according to claim 4 **characterised in that** it is a razor blade.

## Patentansprüche

1. Verfahren zur Bildung eines Überzugs mit einer Dicke von höchstens 200 nm und einer Härte von mindestens 20 GPa aus einem Material mit einer Nanoverbundstruktur auf Titan-, Zirkonium-, Bor- und Stickstoffbasis auf einem Träger (6), **dadurch gekennzeichnet, dass** es folgende Schritte umfasst:
a) Abscheiden durch Magnetron-Kathodenzerstäubung einer Titanschicht (7) auf mindestens einer Oberfläche eines Trägers (6) unter einem Argon-Teildruck von 1 Pa,
b) Abscheiden durch Magnetron-Kathodenzerstäubung einer Titannitridschicht (8) auf der in Schritt a) erhaltenen Schicht (7) durch Einleiten von Stickstoff in den Kathodenzerstäubungsraum (1) unter Beibehaltung eines Teildrucks von 1 Pa,
c) Abscheiden einer Schicht (9) aus Nanostruktur-Verbundmaterial auf Titan-, Zirkonium-, Bor- und Stickstoffbasis auf der in Schritt b) erhaltenen Schicht (8) durch Magnetron-Kathodenzerstäubung im Modus aktiver Ko-Zerstäubung durch Aufbringen einer Leistung X auf ein Titanquellen-Target 3 und einer Leistung Y auf ein ZrB₂-Quellen-Target 2, wobei das X/Y-Verhältnis von 3/5 bis 5/3 beträgt, und durch gleichzeitiges Einspritzen eines aus Argon und Stickstoff bestehenden Gasgemischs, wobei der Stickstoff mindestens 10 Vol.-% des Gesamtvolumens des Gasgemischs bildet, wobei dabei ein Teildruck von 1 Pa beibehalten und eine Polarisationsspannung von -300 V im Kathodenzerstäubungsraum (1) aufgebracht wird.

2. Verfahren nach Anspruch 1, **dadurch gekennzeichnet, dass** in Schritt c) der Stickstoff 10 Vol.-% des Gesamtvolumens des Gasgemischs bildet.

3. Verfahren nach Anspruch 1 oder 2, **dadurch gekennzeichnet, dass** in Schritt c) das X/Y-Verhältnis 1 beträgt.

4. Vorrichtung mit einem Überzug, der mit dem Verfahren nach einem der vorhergehenden Ansprüche erhalten wird.

5. Vorrichtung nach Anspruch 4, **dadurch gekennzeichnet, dass** es sich um eine Rasierklinge handelt.
